# EUROPEAN PATENT APPLICATION

(11) **EP 2 257 144 A2**
(43) Date of publication of application: **01.12.2010**
(21) Application number: 10164337.7
(22) Date of filing: 28.05.2010
(51) Int. Cl.: H05K 5/02

(54) **Cabinet and display apparatus**

(30) Priority: 29.05.2009 JP 2009130220
(71) Applicant: Victor Company of Japan Ltd., Yokohama-shi, Kanagawa (JP)
(72) Inventor: Ishibashi, Hidetoshi, Yokohama-shi Kanagawa (JP); Matsuzawa, Masaru, Yokohama-shi Kanagawa (JP); Okumura, Mikio, Yokohama-shi Kanagawa (JP)
(74) Representative: Jenkins, Peter David

(57) **Abstract**

A cabinet includes a first and a second sub-cabinet having a first and a second inner wall, respectively. The sub-cabinets are fixed to each other so that the inner walls face each other with a gap of a specific distance therebetween. A first and a second rib are laid on the first and second inner walls, respectively. The first and second ribs have an almost same shape as the outer shape of the first and second sub-cabinets, respectively. The first rib is placed outside the second rib at least in a specific direction among upper, lower, left and right directions of the sub-cabinets. The first and second ribs have a height in the specific direction, the height being greater than at least a half of the specific distance.

## Description

### BACKGROUND OF THE INVENTION

The present invention relates to a cabinet and a display apparatus.

A known reinforced thin cabinet for a thin display apparatus, having front and rear sub-cabinets, is provided with an aluminum-bar rectangular frame on the bottom of the rear sub-cabinet (the opposite of a display screen), as a reinforcing member.

A thin cabinet should be mostly lightweight. Thus, such a thin cabinet is mostly formed by front and rear sub-cabinets of light metals, such as aluminum or magnesium, instead of iron materials, when used for thin display panels, such as liquid crystal panels.

However, since young's modulus of light metals is one-third of that of iron materials or lower, light metals reduce the stiffness of the front and rear sub-cabinets mentioned above.

Accordingly, such an aluminum-bar rectangular frame for the known cabinet mentioned above may not always provide enough stiffness, or inevitably provides lower stiffness as a display screen becomes larger.

### SUMMARY OF THE INVENTION

A purpose of the present invention is to provide a thin and lightweight cabinet having front and rear sub-cabinets, that exhibits high stiffness.

Another purpose of the present invention is to provide a display apparatus with a thin and lightweight cabinet having front and rear sub-cabinets, that exhibits high stiffness.

The present invention provides a cabinet comprising: a first sub-cabinet having a first inner wall; a second sub-cabinet having a second inner wall, the first and second sub-cabinets being fixed to each other so that the first and second inner walls face each other with a gap of a specific distance therebetween; a first rib laid on the first inner wall of the first sub-cabinet, the first rib having an almost same shape as an outer shape of the first sub-cabinet; and a second rib laid on the second inner wall of the second sub-cabinet, the second rib having an almost same shape as an outer shape of the second sub-cabinet, wherein the first rib is placed outside the second rib at least in a specific direction among upper, lower, left and right directions of the first and second sub-cabinets, the first and second ribs having a height in the specific direction, the height being greater than at least a half of the specific distance.

Moreover, present invention provides a display apparatus comprising: a first sub-cabinet having a first inner wall with an opening; a second sub-cabinet having a second inner wall, the first and second sub-cabinets being fixed to each other so that the first and second inner walls face each other with a gap of a specific distance therebetween; a display panel having a display screen, the display panel being interposed between the first and second sub-cabinets so that the display screen is exposed through the opening of the first sub-cabinet; a first rib laid on the first inner wall of the first sub-cabinet but outside the display panel at least in a specific direction among upper, lower, left and right directions of the display panel, the first rib having an almost same shape as an outer shape of the first sub-cabinet; and a second rib laid on the second inner wall of the second sub-cabinet but outside the display panel at least in the specific direction, the second rib having an almost same shape as an outer shape of the second sub-cabinet, wherein the first rib is placed outside the second rib, or vise versa, in the specific direction, the first and second ribs having a height in the specific direction, the height being greater than at least a half of the specific distance.

### BRIEF DESCRIPTION OF DRAWINGS

FIG. 1 is an external perspective view of a display apparatus, an embodiment of the present invention, viewed from the front right upper side;
FIG. 2 is an external perspective view of the display apparatus, the embodiment of the present invention, viewed from rear left upper side;
FIG. 3 is an exploded view of the display apparatus, the embodiment of the present invention;
FIG. 4 is an exploded view of a front sub-cabinet of the display apparatus, the embodiment of the present invention;
FIG. 5 is a perspective view of the front sub-cabinet of a cabinet, an embodiment of the present invention;
FIG. 6 is a fragmentary enlarged perspective view of the front sub-cabinet of the cabinet, the embodiment of the present invention;
FIG. 7 is an exploded view of a rear sub-cabinet of the cabinet, the embodiment of the present invention;
FIG. 8 is a perspective view of the rear sub-cabinet of the cabinet, the embodiment of the present invention;
FIG. 9 is a fragmentary enlarged perspective view of the rear sub-cabinet of the cabinet, the embodiment of the present invention;
FIG. 10 is a perspective view of an LED circuit board of the display apparatus, the embodiment of the present invention;
FIG. 11 is a perspective sectional view showing the LED circuit board installed in the display apparatus, the embodiment of the present invention;
FIG. 12 is a sectional view showing the upper side configuration of the cabinet of the display apparatus, the embodiment of the present invention;
FIG. 13 is a sectional view showing the left side configuration of the cabinet of the display apparatus, the embodiment of the present invention;
FIG. 14 is a sectional view showing the lower side configuration of the cabinet of the display apparatus, the embodiment of the present invention; and
FIG. 15 is a sectional view showing a modification to the upper side configuration of the cabinet of the display apparatus, the embodiment of the present invention.

### DETAILED DESCRIPTION OF PREFERRED EMBODIMENT

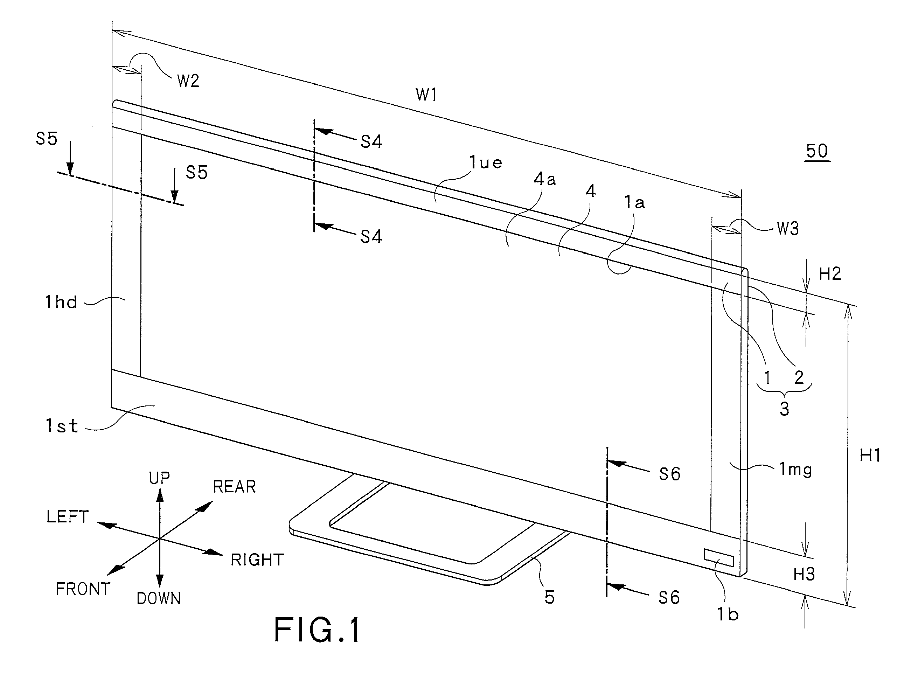

A preferred embodiment of the present invention will be described with respect to FIGS. 1 to 15.

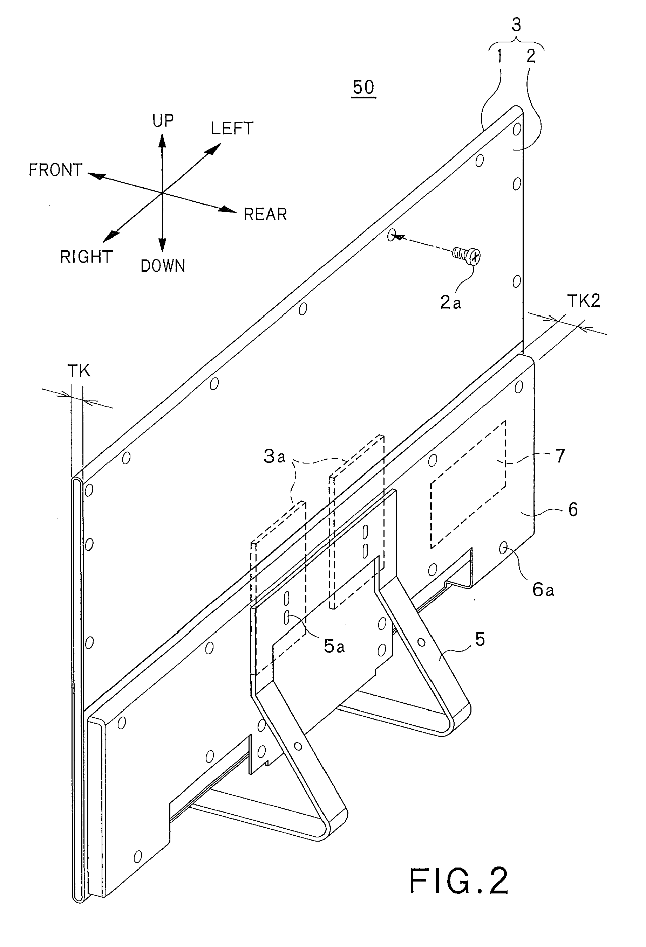

FIG. 1 shows an external perspective view of a display apparatus 50, an embodiment of the present invention, viewed from the front right upper side. FIG. 2 shows another external perspective view of the display apparatus 50, viewed from the rear left upper side.

It is defined hereinafter that one side of the display apparatus 50 from which a display screen can be seen is termed as "a front side". The terms "up", "down", "left", "right", front" and "rear" are indicated in the drawings if necessary, each indicating a particular direction with respect to the display apparatus 50 and being used in the following description.

The display apparatus 50 described hereinafter as an embodiment is a 32-inch monitor having a liquid crystal panel for displaying images carried by externally incoming video signals.

The display apparatus 50 shown in FIG. 1 has a cabinet 3 formed by combining a frame-like front sub-cabinet 1 and a rear sub-cabinet 2. Installed in the cabinet 3 is a liquid crystal panel 4 having a display screen 4a exposed through an opening 1a of the front sub-cabinet 1. The cabinet 3 is supported by a stand 5 provided at a rear side thereof so that the display apparatus 50 can be set on a flat surface, such as a floor. The cabinet 3 may, however, be hung from a ceiling or on a wall, without the stand 5.

The front sub-cabinet 1 is a rectangular frame formed by: an upper frame member 1ue and a lower frame member 1st, each having a length reaching the left and right ends of the front sub-cabinet 1; and a left frame member 1hd and a right frame member 1mg that join the upper and lower frame members 1ue and 1st at the left and right ends of the front sub-cabinet 1, respectively. Provided at the right side of the lower frame member 1st is a light-receiving window 1b for receiving light from a remote controller (not shown).

As shown in FIG. 2, provided at the lower side of the rear sub-cabinet 2 of the cabinet 3 is an LED-DRV circuit board 7 equipped with a controller for controlling LED light sources which will be described later. A circuit cover 6 is fixed to the rear sub-cabinet 2 with several male screws 6a to cover the circuit board 7

The stand 5 is fixed to die-cast frames 3a provided inside the rear sub-cabinet 2, with several male screws 5a.

The cabinet 3 is assembled by fixing the rear sub-cabinet 2 to the front sub-cabinet 1 with several male screws 2a (only one screw 2a shown in FIG. 2) at the rear side, which will be described later in detail.

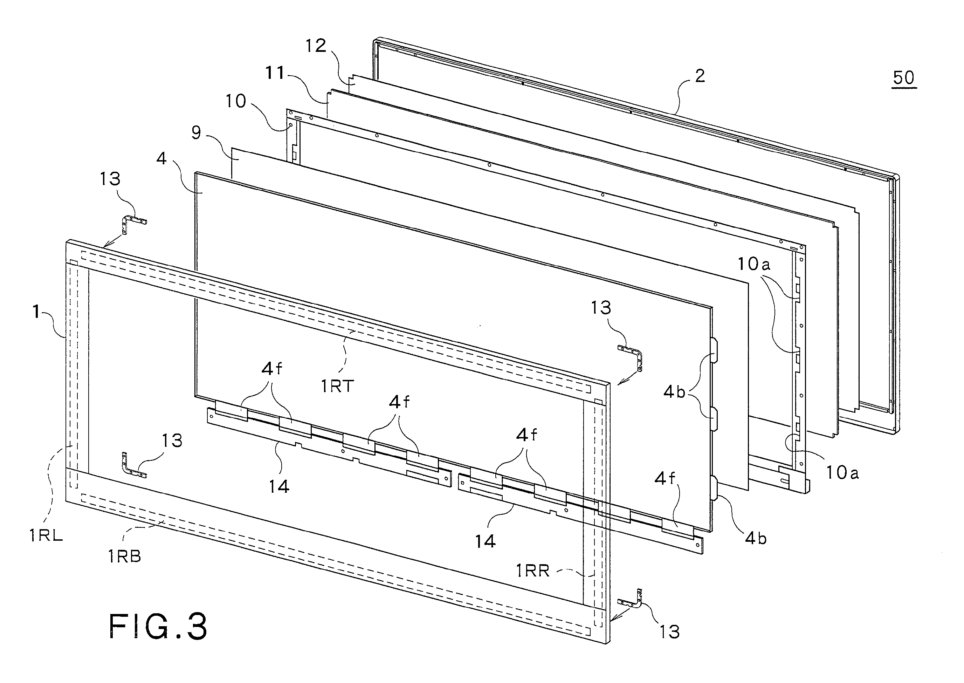

FIG. 3 is an exploded view of the display apparatus 50.

The display apparatus 50 includes the front sub-cabinet 1, the liquid crystal panel 4, an optical sheet 9, a panel chassis 10, a light guide panel 11, a reflection sheet 12, and the rear sub-cabinet 2, arranged from the front side.

Provided at the four corners of the front sub-cabinet 1 are front brackets 13, each being an L-shaped metallic member. The front brackets 13 are used for forming the front sub-cabinet 1 into the rectangular frame with the upper and lower frame members 1ue and 1st, and the left and right frame members 1hd and 1mg, as shown in FIG. 1, which will be described later in detail. The frame members 1ue, 1st, 1hd and 1mg have ribs 1RT, 1RB, 1RL and 1RR, respectively, each rib provided inside the corresponding frame member.

Provided at the lower edge of the liquid crystal panel 4 are a pair of LCD-DRV circuit boards 14 each equipped with a driver circuit (not shown) for driving the liquid crystal panel 4 as a display panel via flexible circuit boards 4f. Sticking out from each of the left and right edges of the liquid crystal panel 4 are three film-like protruding pieces 4b.

The panel chassis 10 is formed into a rectangular frame by resin molding, with concave sections 10a each located at a position corresponding to the associated protruding piece 4b so as not to interfere with each other.

The front sub-cabinet 1 will be described next in detail.

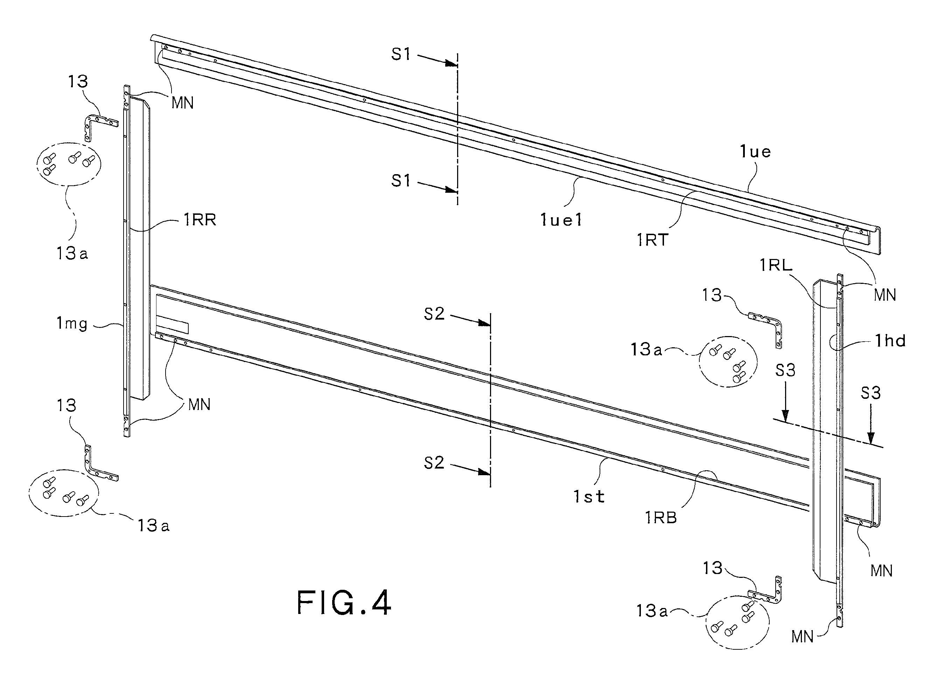

FIG. 4 is an exploded view of a front sub-cabinet of the display apparatus, the embodiment of the present invention, viewed from the rear side.

The upper, lower, left and right frame members 1ue, 1st, 1hd and 1mg are made of aluminum extruding shape material. The frame members are cut into a desired shape and combined into the front sub-cabinet 1.

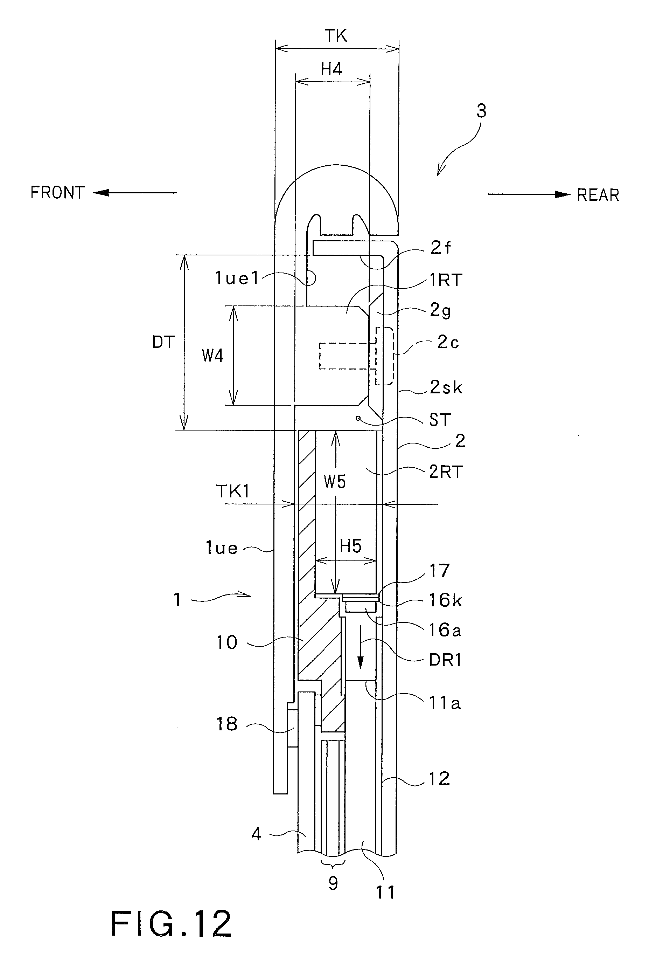

The upper frame member 1ue is shown in FIG. 12 that is a section taken on line S1 - S1 in FIG. 4. The upper frame member 1ue is provided with the rib 1RT on a surface 1ue1 at the rear side so that the rib 1RT lies along the frame member 1ue in left and right.

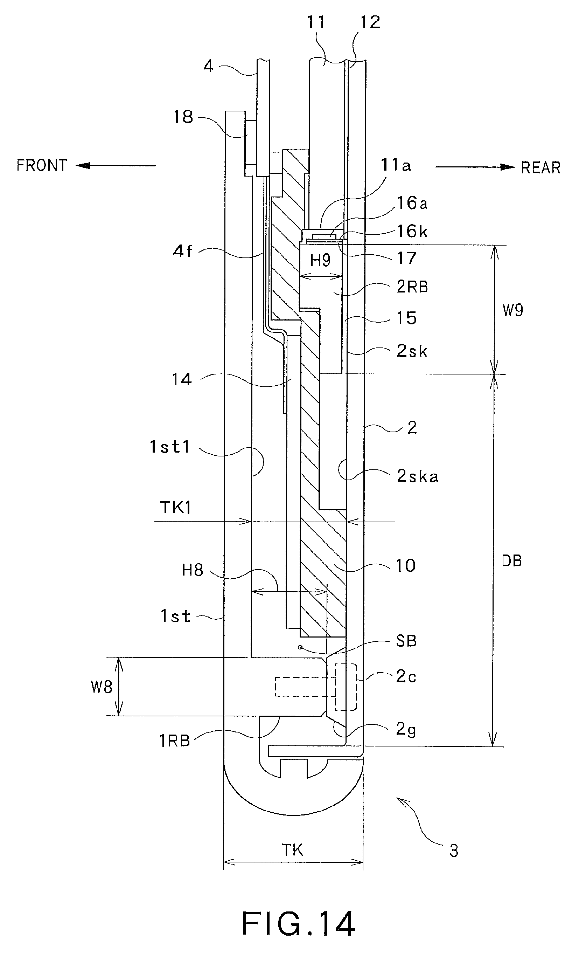

The lower frame member 1st is shown in FIG. 14 that is a section taken on line S2 - S2 in FIG. 4. The lower frame member 1st is provided with the rib 1RB on a surface 1st1 at the rear side so that the rib 1RB lies along the frame member 1st in left and right.

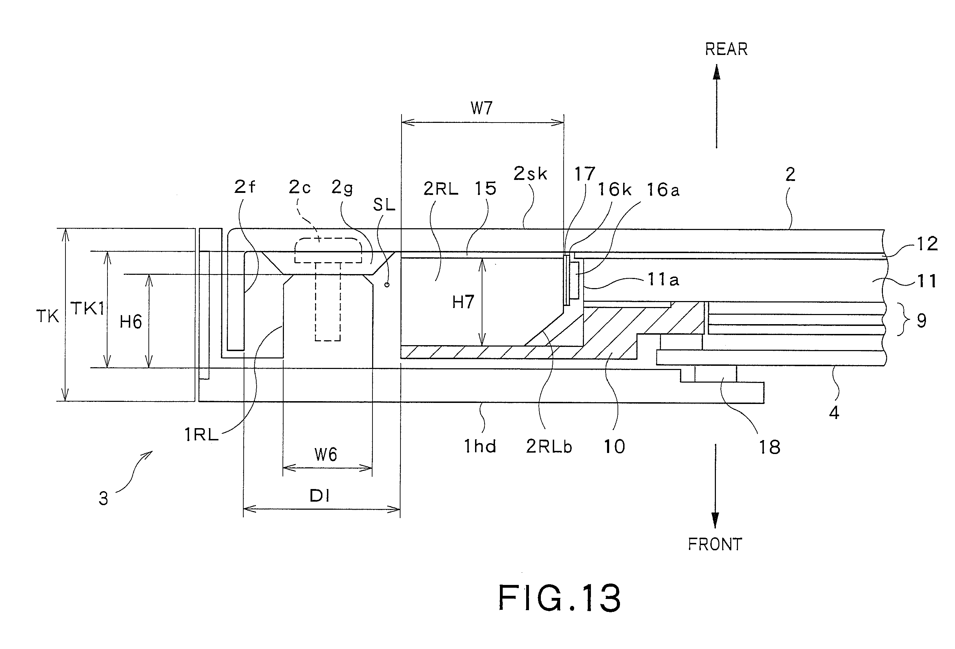

The left frame member 1hd is shown in FIG. 13 that is a section taken on line S3 - S3 in FIG. 4. The right frame member 1mg has a symmetrical shape with the left frame member 1hd in section.

Each of the frame members 1ue, 1st, 1hd and 1mg made of aluminum extruding shape material is cut into a step-like shape at both ends thereof by secondary procedure so that the frame members can be engaged with one another at the step-like ends.

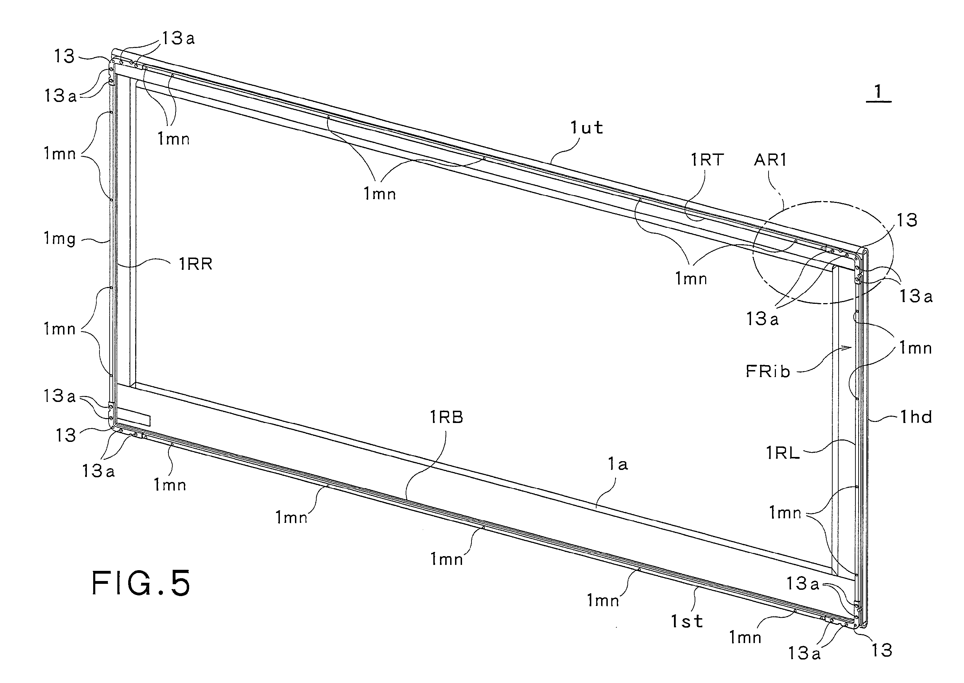

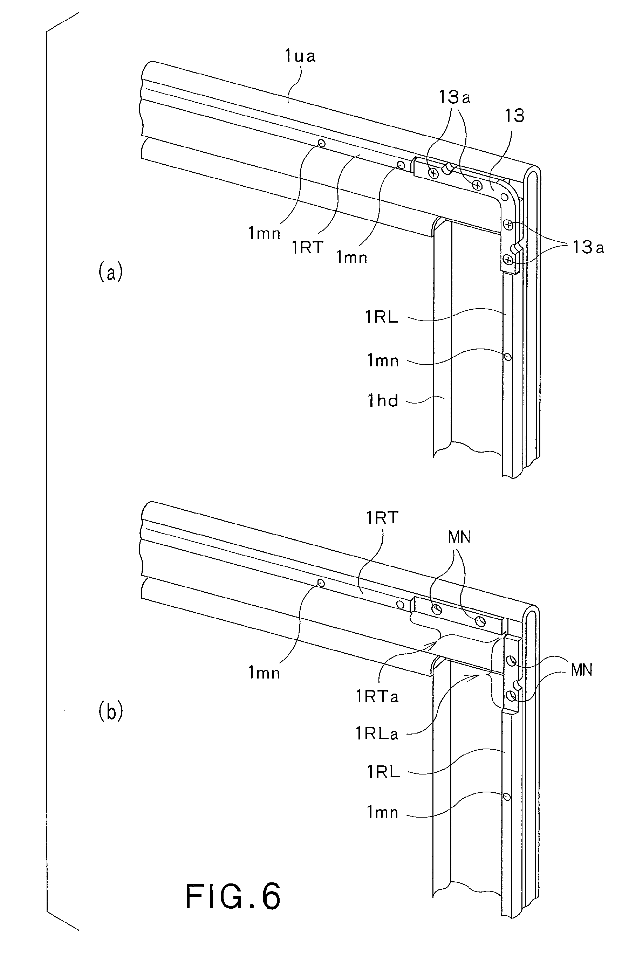

Each of the ribs 1RT, 1RB, 1RL and 1RR is provided with female screws MN in the vicinity of both ends thereof, as shown in FIG. 4. Moreover, as shown in FIGS. 5 and 6, each rib is provided with female screws 1mn in the vicinity of the female screws MN.

In assembling the front sub-cabinet 1: the upper frame member 1ue is engaged at both ends thereof with the left and right frame members 1hd and 1mg at the upper ends thereof; and the lower frame member 1st is engaged at both ends thereof with the left and right frame members 1hd and 1mg at the lower ends thereof, with the front brackets 13 and male screws 13a inserted thereinto and screwed into the female screws MN, as shown in FIGS. 4 and 5.

FIG. 5 is a perspective view of the assembled front sub-cabinet 1 viewed from the rear side. FIG. 6 is an enlarged view of a right upper corner AR1 of the front sub-cabinet 1 shown in FIG. 5, in which (a) shows the right upper corner AR1 having the front bracket 13 with the male screws 13a whereas (b) with no front bracket 13 and male screws 13a.

As shown in (b) of FIG. 6, the ribs 1RT and 1RL have fixing zones 1RTa and 1RLa, respectively, at ends thereof, cut into a specific depth so that the front bracket 13 can be fit therein. The depth of the fixing zones 1RTa and 1RLa is almost equal to the thickness of the front bracket 13. Thus, when the front bracket 13 is fit in the fixing zones 1RTa and 1RLa as covering the ends of the ribs 1RT and 1RL, as shown in (a) of FIG. 6, the front bracket 13 and the ribs 1RT and 1RL become almost flat with respect to each other at the rear side.

The configuration of the right upper corner AR1 described with respect to FIG. 6 is also applied to the other three corners of the front sub-cabinet 1.

As described above, the four ribs 1RT, 1RB, 1RL and 1RR are joined to one another with the four front brackets 13 to form a rectangular rib frame FRib in the front sub-cabinet 1.

Accordingly, although the four upper, lower, left and right frame members 1ue, 1st, 1hd and 1mg are separate members, the assembled front sub-cabinet 1 has the stiffness almost the same as the one assembled with a single rectangular frame. Moreover, the four ribs 1RT, 1RB, 1RL and 1RR joined to one another as described above offer high reinforcement to the front sub-cabinet 1 almost the same as the one assembled with a single rectangular rib.

The rear sub-cabinet 2 will be described next in detail.

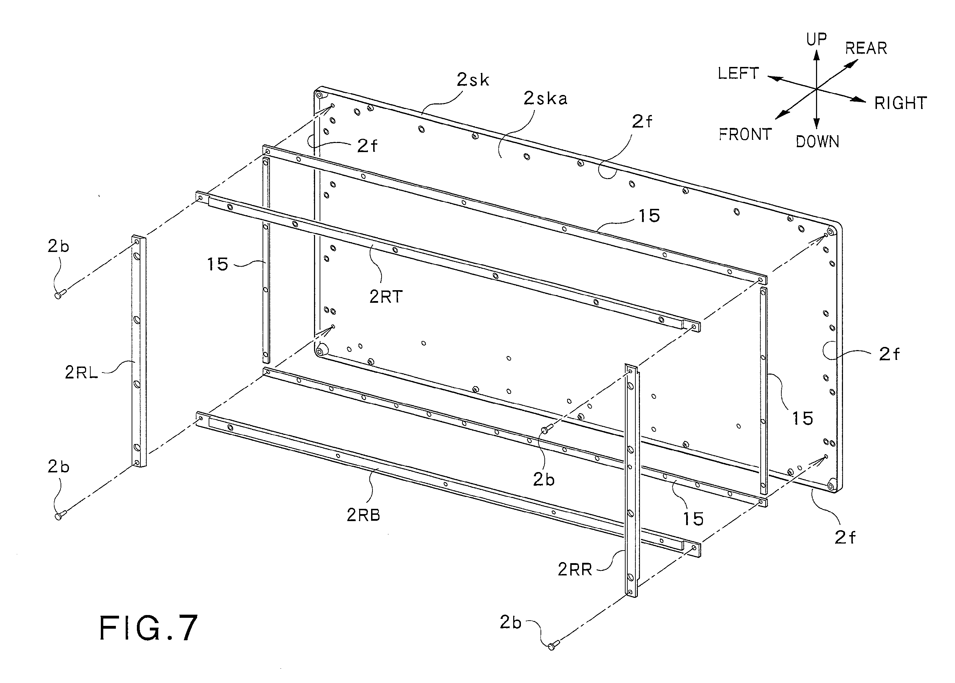

FIG. 7 is an exploded view of the rear sub-cabinet 2, viewed from front right upper side. The rear sub-cabinet 2 includes: a base plate 2sk; an upper rib 2RT, a lower rib 2RB, a left rib 2RL and a right rib 2RR, each attached to the base plate 2sk; four heat dissipating sheets 15 interposed between the base plate 2sk and the four ribs; and male screws 2b for fixing the ribs 2RT, 2RB, 2RL and 2RR, and the heat dissipating sheets 15 to the base plate 2sk at the four corners of the plate. The ribs 2RT, 2RB, 2RL and 2RR are also fixed to the base plate 2sk with male screws (not shown).

The base plate 2sk is formed, for example, by press working to a 1. 0-mm-thick aluminum plate. Each of the four edges of the base plate 2sk has a flange 2f at a height of about 4. 6 mm from an inner surface 2ska of the base plate 2sk.

Each of the ribs 2RT, 2RB, 2RL and 2RR is made of aluminum extruding shape material and cut into a bar shape, applied with necessary secondary procedure, such as cutting.

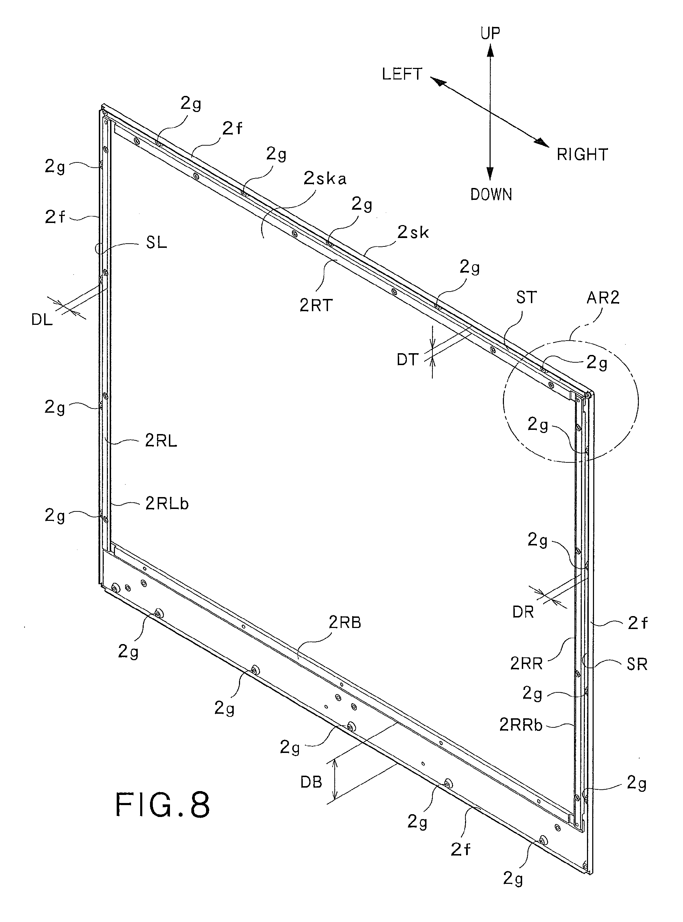

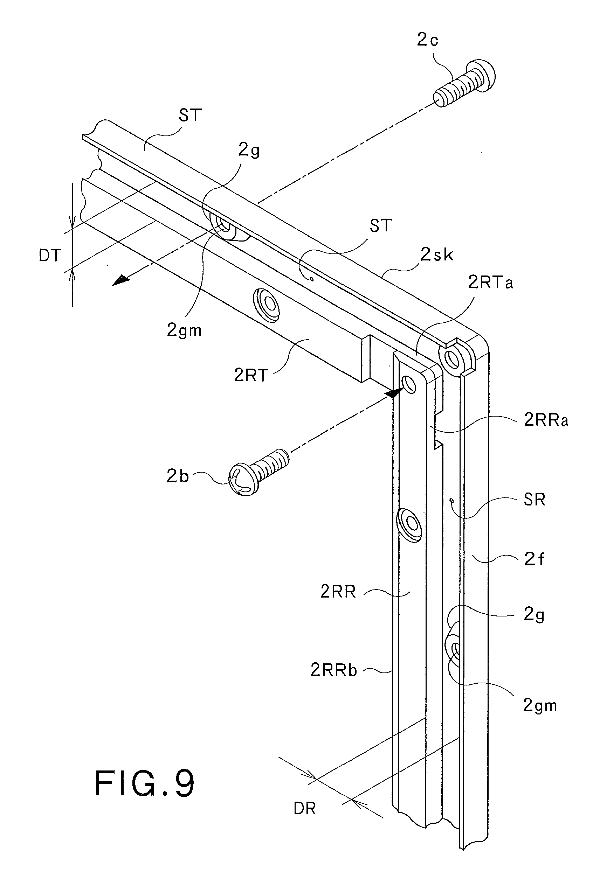

FIG. 8 is a perspective view of the rear sub-cabinet 2 with the base plate 2sk having the ribs 2RT, 2RB, 2RL and 2RR fixed thereto, viewed from the front right upper side. FIG. 9 is an enlarged view of a right upper corner AR2 of the rear sub-cabinet 2 shown in FIG. 8, with the male screw 2b before screwed into the base plate 2sk.

The rib 2RT is gouged at each of both ends from the front side to have a thin wall section 2RTa. The rib 2RR is gouged at each of both ends from the rear side to have a thin wall section 2RRa. The total thickness of the wall sections 2RTa and 2RRa is almost equal to the thickness of each of the ribs 2RT and 2RR.

The rib 2RR is laid on the rib 2RT at the thin wall sections 2RTa and 2RRa and fixed to the base plate 2sk with the male screw 2b.

The configuration shown in FIG. 9 for the ribs 2RT and 2RR at the right upper corner AR2 (FIG. 8) is also applied to the other ribs that are joined to each other at the other corners in FIG. 8.

As described above, the four ribs 2RT, 2RB, 2RL and 2RR are joined to one another to form a rectangular rib frame RRib in the rear sub-cabinet 2.

Accordingly, the four ribs 2RT, 2RB, 2RL and 2RR joined to one another as described above offer high reinforcement to the rear sub-cabinet 2 almost the same as the one assembled with a single rectangular rib.

The rear sub-cabinet 2 is provided with a gap having a specific distance between the internal surface of each flange 2f and the outer surface of the corresponding rib. In detail, as shown in FIGS. 9 and 12, a distance DT is given vertically to a gap ST that is an upper gap between the front and rear sub-cabinets 1 and 2, which is also a gap between the flange 2f of the upper edge of the base plate 2sk and the rib 2RT. As shown in FIG. 14, a distance DB is given vertically to a gap SB that is a lower gap between the front and rear sub-cabinets 1 and 2, which is also a gap between the flange 2f of the lower edge of the base plate 2sk and the rib 2RB. As shown in FIG. 13, a distance DL is given horizontally to a gap SL that is a left gap between the front and rear sub-cabinets 1 and 2, which is also a gap between the flange 2f of the left edge of the base plate 2sk and the rib 2RL. Moreover, as shown in FIG. 9, a distance DR is given (in the same way as the distance DL shown in FIG. 13) horizontally to a gap SR that is a right gap between the front and rear sub-cabinets 1 and 2, which is also a gap between the flange 2f of the right edge of the base plate 2sk and the rib 2RR.

In the embodiment, the distances DL and DR are equally set at 9. 5 mm, the distance DT is set almost equal to the distances DL and DR, and the distance DB is set at 35 mm (longer than the distance DT).

The gaps ST and SR of the base plate 2sk, each being enlarged in FIG. 9, are provided with protrusions 2g that stick out to the front side, each having a through hole 2gm. The protrusions 2g are also provided to the gaps SL and SB in the same manner. In the gap SB, the protrusion 2g is provided closer to the flange 2f.

Attached to the protrusion 2g of the rear sub-cabinet 2 are the ribs 1RT, 1RB, 1RL and 1RR of the front sub-cabinet 1. Each rib is fixed to the corresponding protrusion 2g with a screw inserted to the through hole 2gm, which will be described later in detail.

As shown in FIGS. 8, 9 and 11, the ribs 2RL and 2RR are provided with chamfers 2RLb and 2RRb, respectively, at the edge corners thereof in the front side that face each other but are far from the flanges 2f.

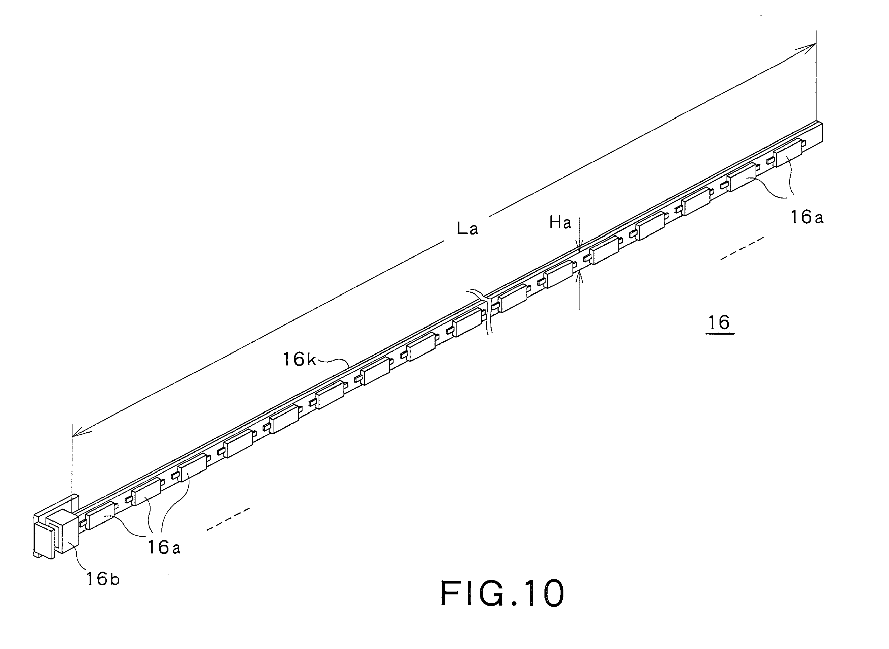

Provided to each of the ribs 2RT, 2RB, 2RL and 2RR of the rear sub-cabinet 2 is an LED circuit board 16, as shown in FIG. 10, at the opposing surfaces of the ribs 2RT and 2RB, and of the ribs 2RL and 2RR, each opposing surface being far from the associated flange 2f. Mounted on a base board 16k of the LED circuit board 16 are several LEDs 16a (a light source, a white LED in the embodiment) and an LED driver (not shown) for driving each LED 16a. The controller mounted on the LED-DRV circuit board 7 shown in FIG. 2 has a function of total control of the LEDs 16a of the LED circuit boards 16.

In the display apparatus 50 shown in FIG. 3, light from the LEDs 16a is incident on the light guide panel 11 at the side faces thereof (each side face being an light-incident surface 11a, as shown in FIG. 12) so that the liquid crystal panel 4 can emit light.

There are four LED circuit boards 16 in total, in the embodiment, at the four ribs 2RT, 2RB, 2RL and 2RR of the rear sub-cabinet 2, so as to associate with the four edges of the light guide panel 11 so that light from each LED circuit board 16 can be incident on the light guide panel 11 at the corresponding edge thereof.

Each LED 16a is a light source and also a heat source because it emits light and gives off heat while the display apparatus 50 is operating.

As shown in FIG. 10, the base board 16k of the LED circuit board 16 is formed in a slender shape with: a height Ha corresponding to the height of the rib to which the LED circuit board 16 is attached; and a length La that covers the mounted LEDs 16a and corresponds to the length of each edge of the light guide panel 11, light being incident from each edge. The LEDs 16a are mounted on the slender base board 16k at a constant interval. A connector 16b is also mounted on the base board 16k at one end thereof.

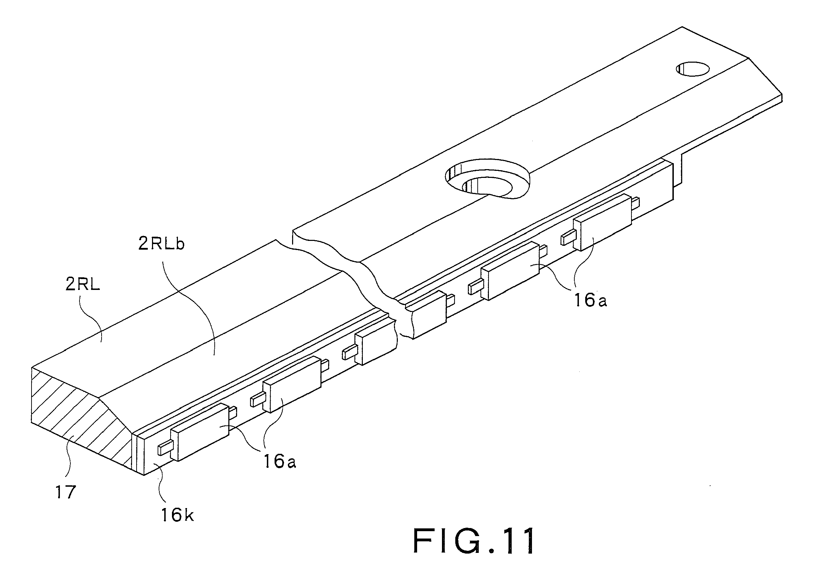

FIG. 11 is a perspective sectional view showing the LED circuit board 16 attached to the rib 2RL with an adhesive tape 17 (although not limited to an adhesive tape).

The front and rear sub-cabinets 1 and 2 are combined with each other with the liquid crystal panel 4, the optical sheet 9, the panel chassis 10, the light guide panel 11, and the reflection sheet 12 installed therebetween, as shown in FIG. 3. Then, the front and rear sub-cabinets 1 and 2 are fixed to each other with male screws 2c shown in FIG. 9. In detail, the male screws 2c are inserted into the through holes 2gm in the protrusions 2g of the base plate 2sk of the rear sub-cabinet 2 and then screwed into the female screws 1mn of the ribs 1RT, 1RB, 1RL and 1RR of the front sub-cabinet 1, shown in FIG. 5.

The internal configuration of the display apparatus 50 will be described with reference to FIGS. 12, 13 and 14 that are sections taken on lines S4 - S4, S5 - S5, and S6 - S6, respectively, in FIG. 1, each with the panel chassis 10 indicated by hatching.

The configuration of the cabinet 3 at the upper side will be described with reference to FIG. 12 that is also a section taken on line S1 - S1 in FIG. 4.

The rib 1RT of the upper frame member 1ue is attached to the protrusion 2g of the base plate 2sk and fixed with the male screw 2c, as described above. The panel chassis 10 is attached to a font-side surface of the rib 2RT and then fixed to the rear sub-cabinet 2 with a fixing means (not shown).

Provided between the display panel 4 and the upper frame member 1ue is a buffer member 18, such as a sponge or another type of resin material, or rubber material.

Each LED 16a is provided to face the light-incident surface 11a that is a side face of the light guide panel 11.

In the configuration described above, the front sub-cabinet 1 is in mechanical contact with the rear sub-cabinet 2 and several members connected to the rear sub-cabinet 2, only with the protrusions 2g and the male screws 2c, with other sections having a small gap.

The heat given off by the LEDs 16a (as the heat source) is transferred to the rib 2RT via the base board 16k and the adhesive tape 17. There are two routes for the heat to be transferred: one to the panel chassis 10; and the other to the base plate 2sk via the heat dissipating sheet 15. Most of the heat is transferred to the base plate 2sk because the panel chassis 10 is made of resin that exhibits lower thermal conductivity than metal. From the base plate 2sk, the heat is released outside via the rear sub-cabinet 2 and also via the front sub-cabinet 1 through the protrusion 2g. However, the base plate 2sk of the rear sub-cabinet 2, thin but having a large surface area, exhibits high heat radiation, so that most of the heat is efficiently released outside via the rear sub-cabinet 2.

The rib 1RT of the front sub-cabinet 1 is fit in the gap ST with the distance DT so that the rib 1RT is provided over the rib 2RT of the rear sub-cabinet 2 in the vertical direction orthogonal to the front-to-rear direction in FIG. 12. This configuration allows that the ribs 1RT and 2RT have a height (in the direction of a thickness TK of the display apparatus 50) greater than at least 1/2 of an inner-wall distance TK1 of the front and rear sub-cabinets 1 and 2, thus offering a thin cabinet 3 of high stiffness with a small thickness TK. The inner-wall distance TK1 is a distance of the gaps ST, SL and SR in the front-to-rear direction.

The configuration of the cabinet 3 at the left side will be described with reference to FIG. 13 that is also a section taken on line S3 - S3 in FIG. 4. The configuration of the cabinet 3 at the right side is symmetrical with the left side.

The rib 1RL of the left frame member 1hd is attached to the protrusion 2g of the base plate 2sk and fixed with the male screw 2c, as described above.

The panel chassis 10 (indicated by hatching) is attached to a font-side surface of the rib 2RL and then fixed to the rear sub-cabinet 2 with a fixing means (not shown).

The buffer member 18 is also provided between the display panel 4 and the left frame member 1hd.

Each LED 16a is provided to face the light-incident surface 11a that is a side face of the light guide panel 11.

In the left side, the front sub-cabinet 1 is also in mechanical contact with the rear sub-cabinet 2 and several members connected to the rear sub-cabinet 2, only with the protrusions 2g and the male screws 2c, with other sections having a small gap.

The heat given off by the LEDs 16a is transferred to the rib 2RL via the base board 16k and the adhesive tape 17. There are two routs for the heat to be transferred: one to the panel chassis 10; and the other to the base plate 2sk via the heat dissipating sheet 15. Most of the heat is transferred to the base plate 2sk because the panel chassis 10 is made of resin that exhibits lower thermal conductivity than metal. From the base plate 2sk, the heat is released outside via the rear sub-cabinet 2 and also via the front sub-cabinet 1 through the protrusion 2g. However, the base plate 2sk of the rear sub-cabinet 2, thin but having a large surface area, exhibits high heat radiation, so that most of the heat is efficiently released outside via the rear sub-cabinet 2.

The rib 1RL of the front sub-cabinet 1 is fit in the gap SL with the distance DL so that the rib 1RL is provided under the rib 2RL of the rear sub-cabinet 2 in the vertical direction orthogonal to the front-to-rear direction in FIG. 13. This configuration allows that the ribs 1RL and 2RL have a height (in the direction of the thickness TK of the display apparatus 50) greater than at least 1/2 of the inner-wall distance TK1 of the front and rear sub-cabinets 1 and 2, thus offering a thin cabinet 3 of high stiffness with the small thickness TK.

The configuration of the cabinet 3 at the lower side will be described with reference to FIG. 14 that is also a section taken on line S2 - S2 in FIG. 4.

The rib 1RB of the lower frame member 1st is attached to the protrusion 2g of the base plate 2sk and fixed with the male screw 2c, as described above.

The panel chassis 10 (indicated by hatching) is attached to a font-side surface of the rib 2RB and also an inner surface 2ska of the base plate 2sk, and then fixed to the rear sub-cabinet 2 with a fixing means (not shown).

The buffer member 18 is also provided between the display panel 4 and the lower frame member 1st.

Each LED 16a is provided to face the light-incident surface 11a that is a side face of the light guide panel 11.

Mounted on the panel chassis 10 are the flexible circuit boards 4f and the LCD-DRV circuit boards 14 for driving the liquid crystal panel 4. The LCD-DRV circuit boards 14 are connected to the panel 4 via flexible the circuit boards 4f.

In the lower side, the front sub-cabinet 1 is also in mechanical contact with the rear sub-cabinet 2 and several members connected to the rear sub-cabinet 2, only with the protrusions 2g and the male screws 2c, with other sections having a small gap.

The heat given off by the LEDs 16a is transferred to the rib 2RB via the base board 16k and the adhesive tape 17. There are two routs for the heat to be transferred: one to the panel chassis 10; and the other to the base plate 2sk via the heat dissipating sheet 15. Most of the heat is transferred to the base plate 2sk because the panel chassis 10 is made of resin that exhibits lower thermal conductivity than metal. From the base plate 2sk, the heat is released outside via the rear sub-cabinet 2 and also via the front sub-cabinet 1 through the protrusion 2g. However, the base plate 2sk of the rear sub-cabinet 2, thin but having a large surface area, exhibits high heat radiation, so that most of the heat is efficiently released outside from the rear sub-cabinet 2.

Fit in the gap SB having the distance DB are a portion of each LCD-DRV circuit board 14 and also the rib 1RB of the front sub-cabinet 1 so that the rib 1RB is provided under the rib 2RB of the rear sub-cabinet 2 in the vertical direction orthogonal to the front-to-rear direction in FIG. 14. This configuration allows that the ribs 1RB and 2RB have a height (in the direction of the thickness TK of the display apparatus 50) greater than at least 1/2 of the inner-wall distance TK1 of the front and rear sub-cabinets 1 and 2, thus offering a thin cabinet 3 of high stiffness with the small thickness TK.

As described above, most of the heat given off by the LEDs 16a is efficiently released outside from the rear sub-cabinet 2 via the base plate 2sk that exhibits high heat radiation, not from the front sub-cabinet 1, thus the temperature increase being restricted in the cabinet 3. Moreover, with the base plate 2sk, the temperature increase in highly restricted in the rear sub-cabinet 2 and much higher in the front sub-cabinet 1.

Moreover, when the display apparatus 50 is assembled, the front sub-cabinet 1 is formed by the separate upper, lower, left and right frame members 1ue, 1st, 1hd and 1mg, and the rear sub-cabinet 2 is also formed by the separate upper, lower, left and right frame members 2ue, 2st, 2hd and 2mg.

However, the frame members 1ue, 1st, 1hd and 1mg are supported by the ribs 1RT, 1RB, 1RL and 1RR that form the single rectangular rib frame FRib, each rib having almost the same shape as the outer shape of the front sub-cabinet 1. The ribs 2RT, 2RB, 2RL and 2RR also form the single rectangular rib frame RRib, each rib having almost the same shape as the outer shape of the rear sub-cabinet 2.

When the front and rear sub-cabinets 1 and 2 are combined into the cabinet 3, the single rectangular rib frames FRib and RRib are arranged so that the frame FRib surrounds the frame RRib, or the frame FRib is placed outside the frame RRib in the upper, lower, left and right directions of the cabinet 3.

The cabinet 3, assembled as described above, exhibits high stiffness even though the front and rear sub-cabinets 1 and 2 are formed by the frame members made of light metal, aluminum extruding shape material in the embodiment. This is because the single rectangular rib frames FRib and RRib have a height (in the direction of the thickness TK of the display apparatus 50) greater than at least 1/2 of the inner-wall distance TK1 of the front and rear sub-cabinets 1 and 2, as explained for each of the upper, lower, left and right ribs.

Therefore, with the cabinet 3 described above, the display apparatus 50 becomes lightweight but exhibits high stiffness.

In the display apparatus 50, the rectangular rib frames FRib and RRib of the front and rear sub-cabinets 1 and 2, respectively, are provided so that the rib frame FRib sticks out towards the inner surface of the rear sub-cabinet 2 and the rib frame RRib sticks out towards the inner surface of the front sub-cabinet 1, at the four edges of the liquid crystal panel 4.

Modifications may be made to the embodiment without departing from the scope of the present invention.

For example, in the embodiment, the rectangular rib frames FRib and RRib are arranged so that the frame FRib surrounds the frame RRib, or the frame FRib is placed outside the frame RRib in the upper, lower, left and right directions of the cabinet 3. However, the frame RRib may be placed outside the frame FRib in the upper, lower, left and right directions of the cabinet 3. This is achieved, for example, by forming the front sub-cabinet 1 into the configuration shown in FIG. 9 for the rear sub-cabinet 2.

Moreover, in the embodiment, the front sub-cabinet 1 is formed into a rectangular frame with the separate upper, lower, left and right frame members 1ue, 1st, 1hd and 1mge. However, the front sub-cabinet 1 may be formed into a rectangular frame with a single rectangular member, the same being applied to the rear sub-cabinet 2.

Furthermore, in the embodiment, the four ribs 1RT, 1RB, 1RL and 1RR are engaged at the four corners with the front brackets 13 to form the rectangular rib frame FRib in the front sub-cabinet 1.

Not only that, each of the rib pairs, such as ribs 1RT and 1RL, and 1RB and 1RR, may be formed into an L-shaped rib with a front bracket 13. Such an L-shaped rib formed by two ribs exhibits a higher reinforcement performance than separate ribs without joined to one another. In this modification, the front sub-cabinet 1 has joint sections at which two L-shaped ribs each formed by two ribs are engaged with or joined to each other by the front bracket 13. Moreover, in this modification, the rear sub-cabinet 2 has joint sections at which the adjacent ribs, such as 2RT and 2RL, and 2RB and 2RR, are engaged with or joined to each other by the male screws 2b.

Moreover, each of the ribs 1RT, 1RB, 1RL and 1RR, and the ribs 2RT, 2RB, 2RL and 2RR may be a combination of several sub-ribs arranged in parallel and joined to one another with screws.

Furthermore, the rectangular rib frames FRib and RRib described above are solid frames. However, the frames FRib and RRib may be provided with fins to be a lightweight frame.

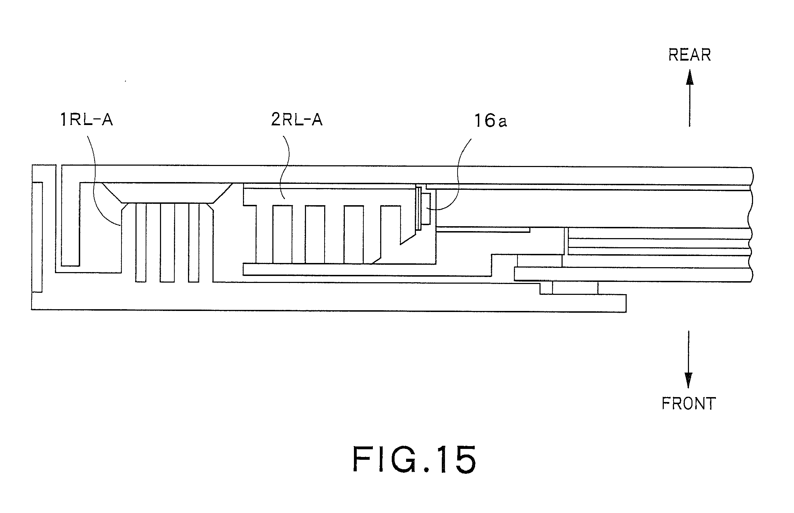

FIG. 15 shows ribs 1RL-A and 2RL-A each provided with fins, as a modification to the ribs 1RL and 2RL, respectively, shown in FIG. 13. In detail, the rib 1RL-A is provided with fins that stick out from the rib in the rear side so that most of the heat given off by the LEDs 16a is released from the rear sub-cabinet 2, not from the front sub-cabinet 1. The rib 2RL-A is also provided with fins that stick out from the rib in front side so that most of the heat given off by the LEDs 16a is released from the rear sub-cabinet 2, not from the front sub-cabinet 1.

The fin-equipped ribs 1RL-A and 2RL-A form air circulation paths in the vertical direction for thermal dissipation, in addition to the routes for heat transfer in the cabinet 3. Air inlets and outlets can be provided at the top and bottom of the cabinet 3 at the location corresponding to the top and bottom of the ribs 1RL-A and 2RL-A, for air circulation that promotes thermal dissipation.

The fin-equipped rib can also be applied as a modification to the ribs 1RR and 2RR.

The dimensions of the 32-inch display apparatus 50 in this embodiment are as follows:

In FIG. 1: 496 mm in height H1 of the cabinet 3; 34. 5 mm in width (height H2) of the upper frame member 1ue; 63. 2 mm in width (height H3) of the lower frame member 1st; 772 mm in width W1 of the cabinet 3; and 34. 4 mm in width W2 (= W3) of the left and right frame members 1hd and 1mg, respectively;

In FIG. 2: 7. 8 mm in thickness TK of the cabinet 3; and about 13 mm in thickness TK2 of the circuit cover 6;

In FIG. 12: 5. 5 mm in inner-wall distance TK1; 5. 4 mm and 3. 5 mm in width W4 and height H4, respectively, of the rib 1RT; and 9 mm and 4. 3 mm in width W5 and height H5, respectively, of the rib 2RT;

In FIG. 13: 5. 4 mm and 4. 5 mm in width W6 and height H6, respectively, of the rib 1RL; and 10 mm and 4 mm in width W7 and height H7, respectively, of the rib 2RL; and

In FIG. 14: 5. 4 mm and 4. 5 mm in width W8 and height H8, respectively, of the rib 1RB; and 12 mm and 2. 5 mm in width W9 and height H9, respectively, of the rib 2RB.

As described above in detail, the present invention offers high stiffness to a thin and lightweight cabinet having front and rear sub-cabinets. Moreover, as described above in detail, the present invention offers high stiffness to a display apparatus with a thin and lightweight cabinet having front and rear sub-cabinets.

## Claims

1. A cabinet comprising:
a first sub-cabinet having a first inner wall;
a second sub-cabinet having a second inner wall, the first and second sub-cabinets being fixed to each other so that the first and second inner walls face each other with a gap of a specific distance therebetween;
a first rib laid on the first inner wall of the first sub-cabinet, the first rib having an almost same shape as an outer shape of the first sub-cabinet; and
a second rib laid on the second inner wall of the second sub-cabinet, the second rib having an almost same shape as an outer shape of the second sub-cabinet,
wherein the first rib is placed outside the second rib at least in a specific direction among upper, lower, left and right directions of the first and second sub-cabinets, the first and second ribs having a height in the specific direction, the height being greater than at least a half of the specific distance.

2. The cabinet according to claim 1, wherein at least either the first or the second rib includes at least two sub-ribs joined to each other.

3. The cabinet according to claim 1, wherein at least either the first or the second rib is a frame-like rib.

4. A display apparatus comprising:
a first sub-cabinet having a first inner wall with an opening;
a second sub-cabinet having a second inner wall, the first and second sub-cabinets being fixed to each other so that the first and second inner walls face each other with a gap of a specific distance therebetween;
a display panel having a display screen, the display panel being interposed between the first and second sub-cabinets so that the display screen is exposed through the opening of the first sub-cabinet;
a first rib laid on the first inner wall of the first sub-cabinet but outside the display panel at least in a specific direction among upper, lower, left and right directions of the display panel, the first rib having an almost same shape as an outer shape of the first sub-cabinet; and
a second rib laid on the second inner wall of the second sub-cabinet but outside the display panel at least in the specific direction, the second rib having an almost same shape as an outer shape of the second sub-cabinet,
wherein the first rib is placed outside the second rib, or vise versa, in the specific direction, the first and second ribs having a height in the specific direction, the height being greater than at least a half of the specific distance.

5. The display apparatus according to claim 4, wherein at least either the first or the second rib includes at least two sub-ribs joined to each other.

6. The display apparatus according to claim 4, wherein at least either the first or the second rib is a frame-like rib.

7. The display apparatus according to claim 4 further comprising:
a light source for the display panel; and
a support for holding the light source, the support being fixed to the second rib.
